(19) Europäisches Patentamt

European Patent Office

Office européen des brevets

(11) Publication number: **0 144 205 B1**

(12) **EUROPEAN PATENT SPECIFICATION**

(45) Date of publication of patent specification: **17.03.93**  (51) Int. Cl.⁵: **H01S 3/19, H01S 3/06**

(21) Application number: **84308195.1**

(22) Date of filing: **26.11.84**

(54) **Semiconductor laser.**

(30) Priority: **01.12.83 US 556879**
　　　　　**20.07.84 US 632767**

(43) Date of publication of application:
**12.06.85 Bulletin 85/24**

(45) Publication of the grant of the patent:
**17.03.93 Bulletin 93/11**

(84) Designated Contracting States:
**DE FR GB NL SE**

(56) References cited:
**EP-A- 0 010 949**　　**EP-A- 0 045 862**
**WO-A-85/00076**　　**FR-A- 2 512 286**
**GB-A- 2 112 201**　　**US-A- 4 385 389**

(73) Proprietor: **TRW INC.**
**23555 Euclid Avenue**
**Cleveland Ohio 44117(US)**

(72) Inventor: **Morrison, Charles Boswell**
**4259 Newton Street**
**Torrance, California 90505(US)**
Inventor: **Figueroa, Luis**
**3711 W. 230th Street**
**No. 228 Torrance California 90505(US)**
Inventor: **Burghard, Andre**
**23450 Anza**
**No. C, Torrance California 90505(US)**
Inventor: **Goodwin, Frank Eugene**
**9121 Lyon Park Court**
**Burke, Virginia 22015(US)**
Inventor: **Law, Hsiang-Yi David**
**29014 W. Saddleback Drive**
**Agoura, California 91301(US)**

(74) Representative: **Allden, Thomas Stanley et al**
**A.A. THORNTON & CO. Northumberland**
**House 303-306 High Holborn**
**London WC1V 7LE (GB)**

## Description

This invention relates generally to semiconductor lasers, and more particularly, to laser structures for achieving high power outputs, as by incorporating multiple lasing elements into a single device.

By way of background, the basic structure of a p-n junction laser includes an active layer of semiconductor material sandwiched between an n type material and a p type material. A pair of parallel faces of the structure, perpendicular to the plane of the active layer, are cleaved or polished, and the remaining faces are roughened to eliminate lasing in directions other than the desired one. The entire structure is called a Fabry-Perot cavity. When a forward bias voltage is applied across the junction, a current flows. Initially, at low currents, there is spontaneous emission of light from the cavity, in all directions. As the bias is increased, eventually a threshold current is reached at which stimulated emission occurs and a monochromatic and highly directional beam of light is emitted from the junction.

Although many different semiconductor laser geometries have been constructed or proposed, lasers of the double heterostructure type are probably the most widely used. In a double heterostructure (DH) laser, the active layer is sandwiched between two inactive layers that take the form of crystalline solid solutions, such as aluminum gallium arsenide ($Al_xGa_{1-x}As$), where x is the fraction of aluminum arsenide in the material. The DH laser has the advantage of being less temperature dependent and operating at a lower current density than a homostructure laser. Also the DH laser provides a greater difference in refractive index at the boundaries between the active and inactive layers, and therefore confines the light more effectively within the active layer.

Unfortunately, merely increasing the width of a lasing cavity may not result in increased brightness. A wide cavity tends to operate in multiple spatial modes, and the laser light source will then include multiple spots or filaments. This will increase the divergence angle of the resulting beam from the device. For this reason, the brightness, which is the power per unit source area per unit solid angle of the beam, may not be increased at all. Accordingly, there is a need for a more effective technique for providing high power and brightness levels from lasers of this type.

Because merely increasing the size of the laser provides no solution, efforts have been directed to the design of devices with arrays of laser cavities having single-filament lasing properties. One proposed solution takes the form of a phase-locked array of lasers, as described in U.S. Patent No. 4,255,717 to Donald R. Scifres et al., entitled "Monolithic Multi-Emitting Laser Device." In this device, multiple lasing cavities are aligned closely together thereby achieving improvement in beam coherence and divergence properties. However, the brightness of such an array is not higher than that of a single laser of the same power, and the far-field light distribution pattern exhibits a twin-lobe shape that is characteristic of a 180-degree difference in phase between individual emitters in the array. The same is true of other multiple laser arrays, such as the one described by D.E. Ackley et al., "High Power Leaky-Mode Multiple-Stripe Laser," Appl. Phys. Lett., Vol. 39, p. 27 (1981).

Most semiconductor lasers employ a relatively narrow stripe of conductive material to make contact with one of the inactive layers, thereby confining the lasing action to the region aligned with the stripe. This structure is also employed in most laser arrays, multiple stripes being employed to define the multiple lasing regions. One exception to this is a CSP large optical cavity laser array device described by D. Botez, in the proceedings of the International Conference on Integrated Optics and Optical Fiber Communication, Paper 29B52, Tokyo, Japan (1983). The structure of this device includes a relatively wide stripe, in the form of a shallow zinc diffusion region, extending over all of the lasing cavities. However, the device is configured to provide high losses in the regions between laser cavities, so that the effect is still similar to that of an array of separate laser diodes.

Other types of laser arrays include the channeled-substrate-planar (CSP) laser, as described by K. Aiki et al., "Transverse Mode Stabilized $Al_xGa_{1-x}As$ Laser with Channeled Substrate Planar Structure," Appl. Phys. Lett., Vol. 30, p. 649 (1977). This and other similar array structures provide virtually no coupling between the array emitters, and therefore produce an array of lasing spots, each of which is up to 6 microns (micrometers) in width.

Another difficulty associated with semiconductor lasers is that it is sometimes difficult to maintain stable operation in a single desired longitudinal mode or wavelength. This is particularly true when a laser is modulated with a communications signal. Accordingly, an ideal laser for communications applications is one that will maintain a desired longitudinal mode under all conditions.

It has been recognized that the use of a curved active layer junction in a semiconductor laser has a desirable current focusing effect at the center of the device. This is discussed generally in a paper by L. Figueroa and S. Wang entitled "Curved junction stabilized filament (CJSF) double-hetero-structure injection laser," Appl. Phys. Lett. 32, pp. 55-57.

In addition, it has been recognized that mode stabilization of lasers may be achieved by use of a p type substrate and an n type blocking layer for current confinement. See T. Hayakawa et al., "Highly reliable and mode-stabilized (GaAl)As double-heterostructure visible lasers on p-GaAs substrate," Proc. 1981 Intl. Electron Device Meeting, pp. 443-46 (1981).

Various other publications have suggested semiconductor laser structures with curved junctions For example:

R.D. Burnham et al., "Nonplanar large optical cavity GaAs/GaAlAs semiconductor laser," Appl. Phys. Lett. 35, pp. 734-36 (1979);

D. Botez, "CW high-power single-mode operation of constricted double-heterostructure AlGaAs lasers with a large optical cavity, "Appl. Phys. Lett. 36, pp. 190-92 (1980);

D. Botez, "Constricted double-heterostructure AlGaAs diode lasers: structures and electrooptical characteristics," IEEE J. Quantum Electron. QE-17, No. 12, pp. 2290-2309 (1981); and

U.S. Pat. No. 4,215,319 to D. Botez, entitled "Single Filament Laser."

In view of the prior art that has been discussed, there is still a need for further improvement in efficiency, threshold current, and temperature stability of high-power lasers of this general type. The present invention is directed to this end.

It has also been proposed to provide grooves or channels in the substrate of a semi conductor laser for the purpose of shaping layers which are subsequently deposited on the substrate. For example, GB 2112201A discloses a laser diode structure in which grooves are formed in the substrate, whose cooperative effect is to cause the formation of overlying layers of a desired curvature and taper . A buffer layer of the same polarity type material overlies the substrate, partially filling the grooves and the usual active and inactive layers are formed over the buffer layer. A similar laser diode structure is disclosed in US-A-4385389. In this arrangement several pairs of grooves are provided to produce an array of which the region above each pair of grooves constitutes an element.

Thus the present invention aims to provide a multi-emitter semiconductor laser structure operable at high power and high brightness levels, and having a far-field radiation distribution pattern with only a single central, lobe.

Semiconductor laser diode structures according to the invention are defined in claims 1 and 12. Various aspects of the invention and of embodiments thereof are described in the following.

According to a first aspect of the invention the laser structure is characterised by at least two principal lasing regions that are closely coupled together by an intermediate region in which lasing action can also take place. Although the physical explanation for the improved performance of the device is not known in detail, it appears that by providing optical amplification, or at least reduced absorption losses, in this intermediate region, the two principal lasing regions are not only closely spaced but are optically coupled in a desirable in-phase relationship.

Briefly, and in general terms, the semiconductor diode laser structure in this aspect of the invention preferably comprises a p type inactive semiconductor cladding layer, an n type inactive semiconductor cladding layer, an active semiconductor layer disposed between the p type and n type cladding layers, means defining at least two principal lasing regions in the active layer, and means defining an intermediate coupling region between the principal lasing regions. The principal lasing regions are laterally spaced and are in close enough proximity to provide close coupling between the regions. The structure also includes means for applying a bias voltage across the p type and n type lasers in the principal lasing regions and in the intermediate lasing region, to produce reduced losses and possibly optical amplification in the intermediate lasing region and emission of laser light from all three regions.

More specifically, the principal and intermediate lasing regions are preferably of such a width as to result in the production of only a single lasing filament in each region. In an illustrative embodiment of the invention, the means defining the principal lasing regions include a semiconductor substrate on which the structure is formed and two laser channels formed in the substrate, to confine the lasing action in the principal lasing regions. The means defining the intermediate lasing region includes a substrate mesa between the channels, dimensioned to provide net optical amplification or gain in the intermediate lasing region.

Laser structures according to this aspect of the invention preferably include an n type gallium arsenide (GaAs) substrate, a first inactive cladding layer of n type gallium aluminum arsenide ($Ga_{0.65}Al_{0.35}As$) formed over the substrate, an active layer of p type gallium arsenide or gallium aluminum arsenide ($Ga_{0.94}Al_{0.06}As$) formed over the first inactive cladding layer, and a second inactive layer of p type gallium aluminum arsenide ($Ga_{0.65}Al_{0.35}As$) formed over the active layer. Before the first inactive cladding layer is formed, the substrate is etched to define at least two channels extending in a direction parallel to the direction of intended light emission from the active layer. These channels define the principal lasing regions and are similar to two channelled-substrate-planer (CSP) lasers. A top layer of n type gallium arsenide is formed over the second inactive layer, and a deep diffusion region of zinc is formed in the top layer, extending partially into the second inactive layer. The zinc diffusion region has a width that overlaps the two channels.

The two channels are separated by a mesa in the substrate material, the height of which is less than that of the substrate ledges on the opposite sides of the channels. The height of this mesa is chosen to provide sufficient thickness in the first inactive layer to yield reduced absorption losses, and possibly a net optical gain or amplification in the intermediate region between the channels. Preferably, the desired reduction in mesa height is obtained during a fabrication step in which the first inactive layer is formed. A liquid-phase epitaxy (LPE) process is used, and provides a "melt-back" of the mesa before the inactive layer is built up. The mesa, being of smaller width than the substrate ledges on the opposite sides of the channels, is melted back more than these ledges. The result is a mesa of decreased height, which is effective in reducing absorption losses in the intermediate lasing region. The somewhat higher substrate ledges on the other sides of the channels serve to contain the lasing within the principal lasing regions.

A second aspect of the present invention relates generally to a semiconductor laser structure having multiple channels in a substrate, characterised by a blocking layer of opposite polarity type to the substrate, to confine the current flow through the device. Thus, a second aspect of the invention provides a semiconductor laser diode which includes a substrate having at least two parallel channels formed in one of its surfaces, a first inactive cladding semiconductor layer of the same polarity type material as the substrate, a second inactive cladding semiconductor layer of opposite polarity type material, and an active semiconductor layer disposed between the first and second inactive layers, characterised by a blocking layer of opposite polarity type material to the substrate, disposed between the substrate and the first inactive layer, except in a region defining at least two laser channels; and means for applying a bias voltage across the inactive layers, to produce optical gain in the device. The blocking layer and the first inactive layer form a semiconductor junction that is reverse-biased during operation of the device, thereby effectively inhibiting current in any area outside the laser channels.

Preferably, the substrate is of p type material and the blocking layer of n type material. Since the first inactive layer is then also of p type material, which has a lower current conductivity than n type material, there is less lateral current flow through the first inactive layer than in devices based on an n type substrate. In other words, the current distribution tends to remain focused at the center of the device.

As in the first-described aspect of the invention, the laser channels are separated by an intermediate pedestal or mesa formed as part of the substrate. Since the thickness of the first inactive layer above the pedestal is preferably smaller than the thickness of the sane layer directly over the channels, the forward bias voltage across the junction is greatest at center of the region overlying the laser channels, and the current flow is effectively focused at this central position. This focusing mechanism is further enhanced at high currents, and the resulting device has a lower threshold current and a higher efficiency than other similar devices, including the device disclosed in the cross-referenced application.

According to this aspect of the invention, the active layer may be curved convexly toward the substrate. This enhances the current focusing mechanism of the device, since the curvature in current path lengths that are shortened toward the center of the device.

The means for applying a bias voltage across the inactive layers preferably includes a contact stripe disposed over the channel regions of the device. In one version of the invention, the contact stripe is wide in relation to the width of the channels, and the device tends to produce optical gain in two principal regions above the channels. In the intermediate region between the channels there may also be optical gain, or at least a sufficiently reduced loss that the two principal lasing regions are closely coupled together in an in-phase relationship. In another version, the contact stripe is relatively narrow, and the region of optical gain is confined to a single region centered between the channels.

In another preferred form of the invention, the active layer is substantially planar. For reasons not completely understood, the planar version provides closer coupling between the lasing regions and improved mode stability at higher power levels.

In the presently preferred form of the invention, the width of the channels and the width of the intermediate region between channels are selected to be approximately one to two diffusion lengths, so as to support only a single lasing filament. For a gallium aluminum arsenide laser, this width dimension is approximately in the range of 1-8 microns. For wider lasing regions, multi-filament lasing will occur, and the degree of coupling between channels will be lessened, although some advantage may still be obtained from the structure of the invention.

Another aspect of the invention involves the use of multiple coupled lasing regions to provide a selected longitudinal mode of operation. One principal lasing region is defined to provide a different set of longitudinal modes from the other. Because the two regions are closely coupled, the composite of the lasing regions operates only in those modes that are common to both regions. By appropriate design of the principal lasing regions, the structure may be made to operate in a single desired longitudinal mode, which is stable even when the device is subject to modulation. The lasing regions may be designed to produce different longitudinal modes by varying the thickness of the active layer. This changes the effective refractive index of the layer and results in different longitudinal modes of operation. Alternatively, the lasing regions can be defined by channels of different dimensions.

It will be appreciated from the foregoing that the present invention represents a significant advance in the field of semiconductor diode lasers. In particular, the invention provides a high-power, high-brightness laser that is more efficient and has a lower threshold current than its predecessors. Although curvature of the active layer enhances the current focusing ability of the device, the curvature is not a necessary feature of the geometry, since the current focusing mechanism is also contributed to by the geometry of the multiple channels. For this reason there is considerable flexibility in production tolerances needed to control the curvature of the active layer. Other aspects and advantages of the invention will become apparent from the following more detailed description, taken in conjunction with the accompanying drawings.

## BRIEF DESCRIPTION OF THE DRAWINGS

FIGURE 1 is a simplified cross-sectional view of a semiconductor laser structure in accordance with the invention;

FIG. 2 is a cross-sectional view similar to FIG. 1, but including a wider contact stripe to produce optical gain in multiple filaments;

FIG. 3 is a graph showing the far-field radiation distribution characteristic of the device of the invention, at two power levels;

FIG. 4 is a graph showing the power-versus-current characteristic of the device of the invention;

FIG. 5 is a graph showing the output spectrum of the device, plotting relative intensity versus wavelength;

FIG. 6 is a simplified cross-sectional view of another preferred embodiment of the invention, having a planar active layer;

FIG. 7 is a graph showing the near-field radiation distribution characteristic of the structure of FIG. 6;

FIG. 8 is a graph showing the far-field radiation distribution characteristic of the same structure;

FIGS. 9a-9d are diagrammatical representations showing, respectively, multiple longitudinal modes of a first laser cavity, multiple longitudinal modes of a different laser cavity, the gain-versus-wavelength profile of a laser structure, and a single longitudinal mode output from the structure.

FIG. 10 is a cross-sectional view of a twin-channel laser in accordance with the invention;

FIG. 11 is a graph showing the variation of output power with current, for a laser structure like that shown in FIG. 10;

FIG. 12 is a graph showing the near-field light distribution pattern for the same laser structure; and

FIG. 13 is a graph showing the far-field light distribution pattern for the same laser structure.

## DESCRIPTION OF THE PREFERRED EMBODIMENTS

As shown in the drawings for purposes of illustration, the present invention is concerned with improvements in semiconductor lasers. Prior semiconductor laser structures have not been able to provide high power and brightness levels in a completely satisfactory manner.

In accordance with one aspect of the present invention, a multiple-channel semiconductor device is fabricated on a substrate, preferably of p type material, and a preferably n type blocking layer is disposed between the substrate and the first inactive layer, to confine the current flow to the channel regions. The use of a blocking layer in conjunction with the multiple-channel structure provides a current focusing capability not found in other devices, resulting in a lower threshold current, higher efficiency and reduced temperature sensitivity.

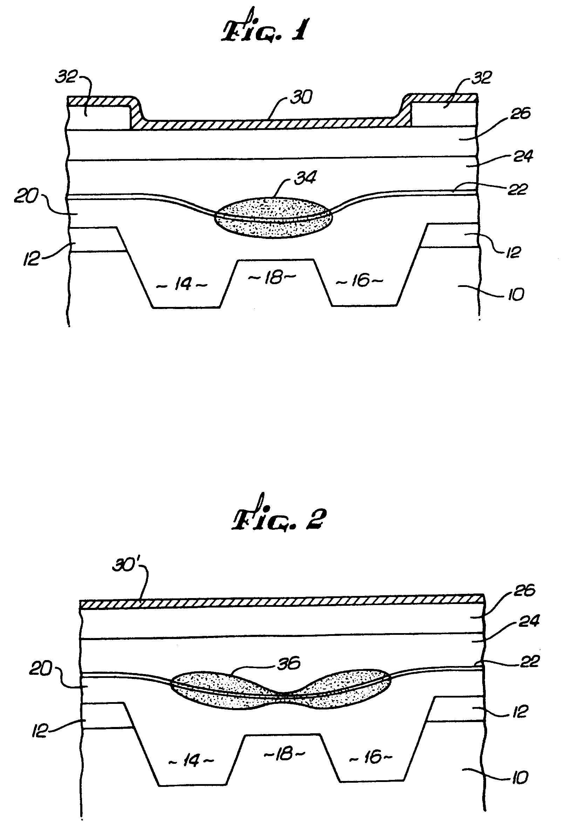

As shown by way of example in FIG. 1, the device of the invention includes a p type substrate, indicated by reference numeral 10, of gallium arsenide (GaAs). The first processing step is growing by liquid phase epitaxy (LPE) an n type layer of gallium arsenide 12, which will serve as the blocking layer. Then the substrate 10 and the blocking layer 12 are etched to define two parallel channels 14 and 16, shown in cross section in FIG. 1. The channels 14 and 16 extend the full length of the device, which is the direction perpendicular to the plane through which the cross-sectional view of FIG. 1 is taken. As shown in the drawings, the blocking layer 12 is completely etched away from the channel regions. A suitable etchant for this step is a solution of sulfuric acid, hydrogen peroxide and water ($H_2SO_4$:$H_2O_2$:$H_2O$). The channel depth in the illustrative embodiment is approximately 1.5 microns ($1.5 \times 10^{-6}$ meter), the channel width is approximately 2-5 microns, and the center-to-center channel spacing is approximately 4-10 microns.

Following the formation of the channels 14 and 16, four additional layers are grown by liquidphase epitaxy to form a semiconductor laser of double-heterostructure (DH) configuration. During the first part of this LPE process, a "melt-back" of an intermediate region or mesa 18 between the channels is obtained, concurrently eliminating the blocking layer from the mesa. The layers include a first inactive cladding layer 20 of p type gallium aluminum arsenide ($Ga_{0.65}Al_{0.35}As$), an active layer 22 of undoped gallium aluminum arsenide ($Ga_{0.94}Al_{0.06}As$), a second inactive cladding layer 24 of n type gallium aluminum arsenide ($Ga_{0.65}Al_{0.35}As$), and a top layer 26 of n type galium arsenide (GaAs). It will be understood that these compositions are merely exemplary. The desired optical properties of the cladding layers could be obtained by use of a variety of materials in the active and inactive layers.

One of the dimensions that has to be selected and controlled with care to ensure proper operation of the structure in accordance with the invention, is the depth of the first inactive layer 20 in the intermediate region above the mesa 18 formed between the two channels 14 and 16. In structures of the prior art, the depth of the first inactive layer between lasing regions is made relatively thin to maximize absorption losses in the intermediate region, thereby ensuring isolation of the lasing regions. Because of the relative crystal bandgap energies of the active layer and the substrate materials, there is a tendency for light generated in the active layer near the intermediate region to be absorbed in the substrate material, if the first cladding inactive layer is thin enough.

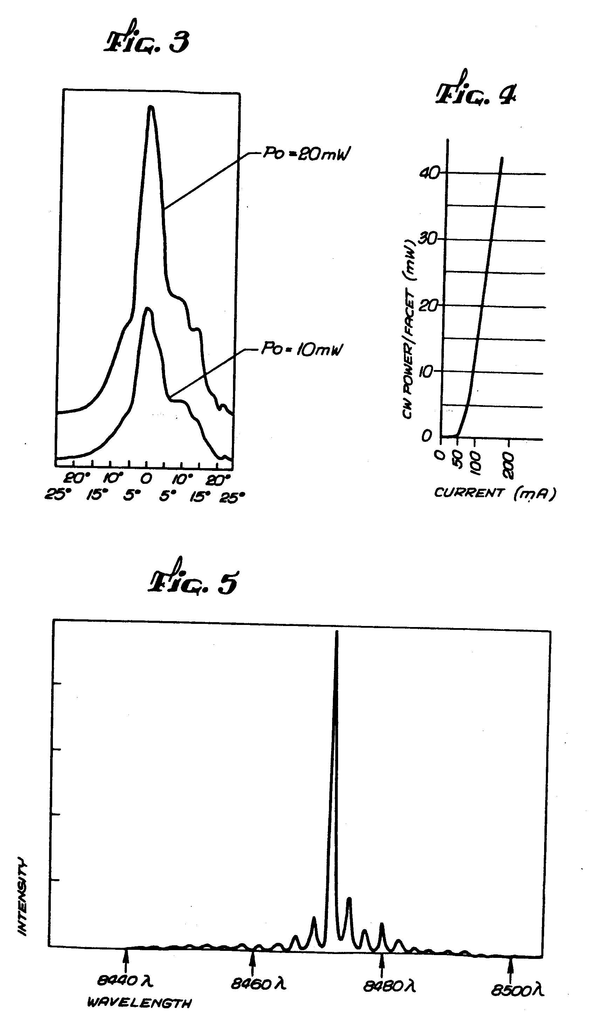

The amount of the absorption loss in the intermediate region between the channels depends on the depth of the first inactive layer 20 and the depth of the active layer 22. The theoretical absorption losses for various layer dimensions have been documented in the technical literature. For example, K. Aiki et al. in "Transverse Mode Stabilized $Al_xGa_{l-x}As$ Injection Lasers with Channeled-Substrate-Planar Structure," IEEE J. Quant. Elect., vol. QE-14, No. 2, p. 89 (1978), provide a graph in their Fig. 2(b) showing the relationship between absorption loss, the thickness of active layer and the thickness of first inactive layer.

With a knowledge of the threshold optical gain that a laser cavity can provide, one can determine from such a graph what the minimum thickness of the first inactive layer 20 should be in order to achieve sufficiently reduced absorption losses in the intermediate lasing region. The threshold gain is, of course, easily determinable from the length of the cavity, the reflectivity of its facets, and other parameters of the semiconductor material. For example, the threshold gain for gallium arsenide lasers is typically in the range of 50-100 $cm^{-1}$. From the absorption loss curves discussed above, one can determine the thickness of the first inactive layer that will result in the same loss as the threshold gain. For gallium arsenide and an active layer thickness of 40-100nm (400-1,000 angstroms), the minimum thickness of the first inactive layer is approximately 0.6 micron. The structure of the invention is preferably configured to provide at least this thickness in the intermediate region, to ensure a positive net optical gain in the intermediate region. For other materials and configurations, similar calculations may be made to determine the minimum thickness of the first inactive layer.

Although the precise nature of the activity in the intermediate region 18 is not understood, it is presently believed that it is not necessary to have a net optical gain in the intermediate region. Instead, there should be a region of reduced absorption losses, to provide coupling between the principal lasing regions.

In the presently preferred fabrication process, the desired thickness of the first inactive layer 20 is obtained by means of the liquid-phase epitaxy (LPE) step used to form the layer 20. The LPE step provides a "melt-back" of the mesa 18 before the inactive layer 20 is built up. Since the mesa 18 is narrower than the ledges on opposite sides of the channels, it is melted back more than the ledges, resulting in a mesa of decreased height, and reduced absorption losses in the intermediate region.

In the embodiments illustrated in FIGS. 1 and 2, the active layer 22 is curved convexly toward the substrate 10 in the region immediately above the intermediate region 18 between the two channels 14 and 16. As will be discussed, this curved-junction geometry serves to enhance the current focusing mechanism of the device, but is not critically necessary to achieving current focusing. Curved semiconductor structures are known to be difficult to reproduce reliably and acurately. However, since the junction curvature in this device is helpful but not absolutely necessary, fabrication of the curvature to fine tolerances is not a requirement. Accordingly, desirably high production yields can be obtained.

A metalization layer 30 is formed over the top layer 26 by conventional fabrication techniques. In the embodiment shown in FIG. 1, the effective width of the metalization layer 30 is approximately the same as the width of the two channels 14 and 16 taken together. Outside of this twin-channel region, there is an insulating layer 32 of silicon nitride ($Si_3N_4$) interposed between the top layer 16 and the metalization layer 30. The narrow effective width of the metallization layer or contact stripe 30 functions to confine the current in such a manner that only a single region of optical gain is formed, as indicated by the shaded area 34 above the intermediate region 20 between the channels 14 and 16.

In the embodiment shown in FIG. 2, there is no silicon nitride layer, and the metalization layer, indicated at 30', extends across the entire width of the top layer 26. In this case, multiple phase-locked optical gain regions are formed, as indicated by the shaded area 36. The near-field pattern of this form of the device basically includes two lobes derived from gain regions formed above the channels 14 and 16, and a center lobe derived from the optical gain above the intermediate region 18. Use of this broad-area contact stripe 30' not only provides multiple phase-locked lasing filaments, but eliminates a processing step by eliminating the insulating layer 32.

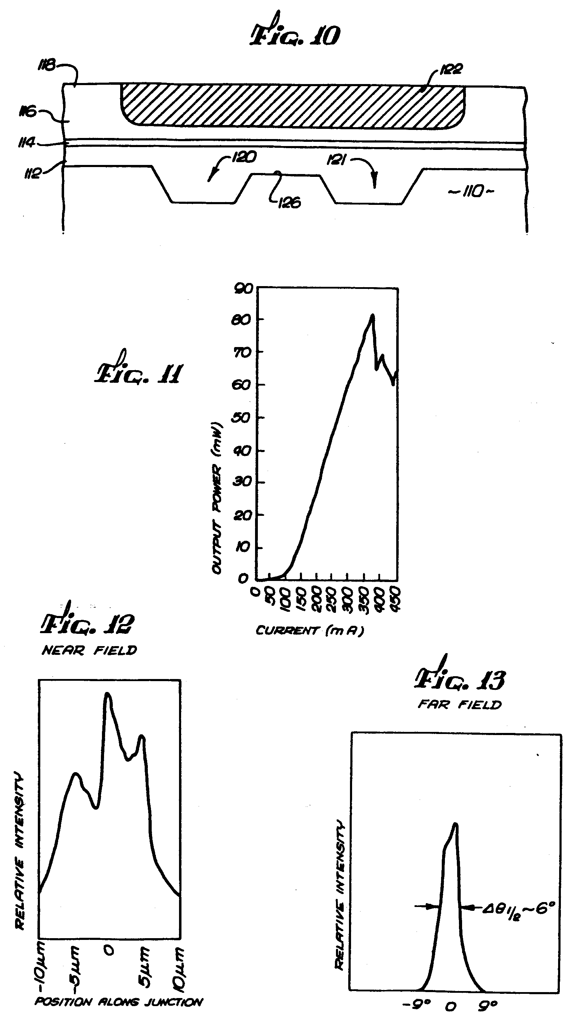

A third embodiment of the invention is shown in FIG. 6. Basically, it is the same as the FIG. 2 embodiment, except that a planar active layer 22' is employed. For reasons that are still not completely understood, this embodiment of the invention provides even better performance characteristics than the FIG. 2 version. In particulars the FIG. 6 device has improved coupling in the intermediate region 18, and better mode stability at high power levels. The optical gain regions, or lasing filaments, are shown schematically at 36'.

One explanation of the improved performance of the planar version has to do with unavoidable thickness variations in a curved active layer, caused by the nature of the LPE process. It has been observed that the thickness of the curved active layer is greatest at the central intermediate region 18. Although this would tend to increase coupling between the principal lasing regions, the gain of a laser varies inversely with the active layer thickness, so that the central region will have reduced gain and hence reduced coupling. It is theorized that this latter effect dominates, which explains the enhanced performance of the planar version of FIG. 6.

FIG. 7 shows the near-field pattern of the device illustrated in FIG. 6. The pattern shows a close coupling between the two principal lasing regions and an intermediate region that has reduced absorption losses, but does not have a positive optical gain. The far-field pattern, shown in FIG. 8 for various power levels up to 50mW, is basically single-lobed, indicating close, in-phase coupling between the lasing regions. These power levels are only exemplary, and the device has been tested to at least as high as 75 mW.

A critical feature of the invention is the current focusing mechanism resulting from the inclusion of the p type substrate 10 and the blocking layer 12 in combination with the multi-channel structure.

The blocking layer 12 functions to practically eliminate current flow through it, since the junction between the blocking layer and the first inactive layer 20 is a reverse-biased n-p junction. Consequently, current from the substrate 10 is forced to flow directly into the first inactive layer 20, through the region including the two channels 14 and 16 and the intermediate region 18.

More specifically, the current focusing mechanism arises because of positionally dependent variations in the voltage drop across the active layer 22. If one considers a current path vertically through the axis of symmetry of the device, the path length through the first inactive layer 20 is considerably shorter than that of a current path displaced to either side of the center. The central path is shorter for two reasons: the convex or downwardly curving active layer 22, and the upwardly extending intermediate region 18 forming a pedestal in the substrate 10. Since the resistivity of the p type inactive layer is relatively high, the differences in path lengths give rise to significant differences in voltage drops along the paths. There will therefore be a smaller voltage drop along the shorter central path than along a path displaced to either side, and the voltage on the lower side of the active layer 22 will be higher in the center than away from the center. There are also path length differences in the second inactive layer 24, but since this layer has a lower resistivity, these differences do not give rise to such significant voltage differences on the upper side of the active layer 22.

The effect of these lateral voltage differences is that the junction formed by the active layer is forward-biased to a greater degree at the center of the device than elsewhere. Since the current through a p-n junction increases exponentially with voltage, this means that the current density through the junction will be greater at the center of the device. In other words, the geometry of the structure results in a current focusing mechanism that concentrates the current toward the center of the device.

In mathematical terms, the difference between the forward bias voltage at the center of the device and the forward bias voltage at some point displaced from the center, is given by the difference between two line integrals $v_p$ and $v_n$, where:

$$v_p = \int \vec{J}_p \cdot d\vec{S}_p / \sigma_p, \text{ and}$$
$$v_n = \int \vec{J}_n \cdot d\vec{S}_n / \sigma_n.$$

In these expressions, $\vec{J}$ is the current density, $d\vec{S}$ is a displacement vector along the active layer 22, and $\sigma$ is the conductivity. The subscripts p and n denote values measured on the p type and n type sides of the junction, respectively. The line integral in each case is taken over limits extending from the center of the device to a desired point of interest displaced from the center. The integral vp, therefore, represents the voltage difference between the center of the device and the displaced position, as measured along the p side of the active layer 22. The integral $v_n$ represents the voltage difference mesured laterally along the n side of the active layer 22. For practical purposes, the integral $v_n$ is close to zero, and the difference between the forward bias at the center and the forward bias at the laterally displaced location is approximately equal to $v_p$.

The current focusing mechanism is self-reinforcing. As more current begins to flow through the center of the device, the forward bias voltage at the central position is increased, and the current through the junction increases exponentially with the forward bias voltage. One important effect of current focusing at the central position is to enhance the fundamental mode stability of the device.

Another important effect of the current focusing mechanism is that the temperature sensitivity of the device is significantly decreased. The threshold current of a semiconductor laser increases with increasing temperature. Basically, the threshold current is a function of $T/T_0$, where T is the temperature and $T_0$ is a constant having same dimensional units as temperature. Typical values of $T_0$ for most lasers are about 160°K. In the device of the invention, $T_0$ is significantly increased, to values in the range of 190°-200°K, meaning that the threshold current will be less dependent on temperature.

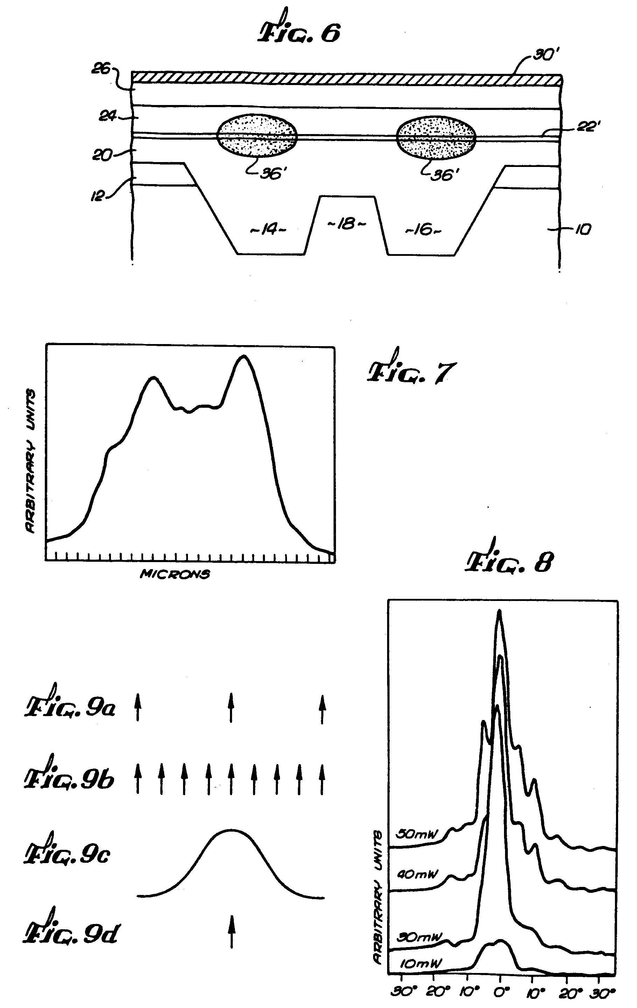

One of the most important advantages of the novel structure of the invention is that the threshold current is dramatically reduced in comparison to similar devices of the same general type. As shown in FIG. 4, the threshold current of the device is only approximately 50 milliamperes (mA), compared with typical values in excess of 100 mA in other devices. Another related effect is that the efficiency of the device increases as the current and power are increased. This is contrary to the characteristic behavior of other devices, in which the efficiency decreases as the current and power are increased. The efficiency is defined as the output power per unit input current, i.e. the slope of the power-current curve in FIG. 4. It will be observed that the steepness of the curve increases slightly as the current and power increase.

FIG. 3 shows the far-field radiation characteristic for the device of the invention, for powers of 10 milliwatts (mW) and 20 mW. The characteristic has a predominant center lobe and only small side lobes. FIG. 5 shows the wavelength spectrum for the device. Basically, the device is monochromatic, with very small components at nearby wavelengths.

Although the dimensions and doping concentrations of the various layers in the device of the invention are not critical, the following values are provided by way of illustration. The substrate 10 has a concentration of $3 \times 10^{18}$ cm$^{-3}$ of a zinc impurity. The blocking layer 12 has a concentration of $1 \times 10^{18}$ cm$^{-3}$ of tellurium (Te) and a thickness of approximately 1.0 micron. The first inactive layer 20 has a concentration of $7\text{-}8 \times 10^{17}$ cm$^{-3}$ of zinc and a thickness of approximately 1.0 micron in the region outside of the channels 14 and 16 and the intermediate region 18. The active layer 22 is undoped and has a thickness of approximately 400-1000 angstroms. The second inactive layer 24 has a concentration of $7\text{-}8 \times 10^{17}$ cm$^{-3}$ of tellurium (Te) and a thickness of approximately 3.0 microns in the region outside of the channels 14 and 16 and the intermediate region 18. Finally, the top layer 26 has a concentration of $1\text{-}2 \times 10^{18}$ cm$^{-3}$ of tellurium (Te) and a thickness of approximately 1.0 micron.

Another important aspect of the invention relates to mode selectivity. In general, each principal lasing cavity is capable of producing a multiplicity of longitudinal modes separated by a wavelength displacement $\Delta\lambda$. $\Delta\lambda$ is given approximately by the expression:

$$\Delta\lambda = \frac{\lambda^2}{2N_{eff} \cdot L}$$

where
λ =            wavelength,
$N_{eff}$ =        effective refractive index, and
L =            length of cavity.

FIGS. 9a and 9b show diagrammatically the longitudinal modes associated with two laser cavities. The longitudinal modes in FIG. 9b are spaced closer together than those in FIG. 9a, either because of differences in length or because of differences in effective refractive index. In accordance with one aspect of the invention, the effective refractive index is varied by fabricating the two channels of the structure to have active layers of different thicknesses. As the thickness of the active layer is reduced, the effective refractive index tends to approach the theoretical refractive index of the surrounding inactive layers, which is lower than the theoretical refractive index of the active layer. Therefore, varying the thickness of the active layer affords some degree of control over the longitudinal mode spacing.

Since the two laser channels are closely coupled by the intermediate region between the channels, only the modes supported by both channels will be produced by the composite device. The close coupling, in effect, results in a logical AND of the two sets of longitudinal modes. Superimposed on this composite mode output characteristic is the gain-wavelength profile of the structure, as shown in FIG. 9c. This profile further filters the output of the device, which may therefore be selected to take the form of a single selected longitudinal mode, as indicated in FIG. 9d. So long as there is close coupling between the two principal lasing regions, the structure will function to provide stable longitudinal mode selection. Mode selection may be also effected by varying the dimensions of the channels 14 and 16, such that each channel produces different longitudinal modes.

Although the foregoing description has been in terms of a specific double heterostructure laser using gallium arsenide and gallium aluminum arsenide as materials, it will be understood that the principles of the invention are equally applicable to other semiconductor laser structures, using other materials. The number of semiconductor materials that exhibit laser action has continued to grow since a GaAs laser device was first demonstrated. At present, virtually all the lasing semiconductor materials have direct bandgaps. Various compound systems of materials from Groups III-V of the Periodic Table are good candidates for laser materials. These may be ternary compounds of the type $A_xB_{1-x}C$, or quaternary compounds of the type $A_xB_{1-x}C_yD_{1-y}$, where A and B are Group III elements and C and D are Group V elements. Two important Group III-V compound solutions are $Al_xGa_{1-x}As_ySb_{1-y}$ and $GA_xIn_{1-x}As_yP_{1-y}$. Group IV-VI compounds, such as PbS, PbTe, PbSe and related solid solutions, also exhibit laser action and may employ the invention to advantage. Just as the invention is not limited to any particular semiconductor materials, neither is it limited to any particular fabrication process. The LPE process used in fabrication of the illustrative embodiment of the invention has the advantage that it melts back the central substrate mesa to produce a desired optical gain in the intermediate region. However, the mesa may be reduced in height by other techniques, such as etching, and an entirely different fabrication process employed.

FIG. 10 shows another embodiment of the invention, in the form of a twin-channel laser fabricated with liquid-phase epitaxy (LPE) techniques, but without the blocking layer of the previously described embodiments. The structure includes a substrate of n or n+ type gallium arsenide, indicated by reference numeral 110, a first inactive cladding layer 112 of n type gallium aluminum arsenide ($Ga_{0.65}Al_{0.35}As$), an active layer 114 of $Ga_{0.94}Al_{0.06}As$, a second inactive layer 116 of the same material as the first inactive layer 112, but of opposite polarity type, and a top layer 118 of n type gallium arsenide.

Prior to formation of the first inactive layer 112, the substrate 110 is etched to define two channels 120 and 121 extending the length of the device, i.e., in a direction perpendicular to the plane through which the cross section of FIG. 10 is taken. A deep diffusion region 122 of zinc forms a contact stripe having a width approximately corresponding to the combined widths of the two channels 120 and 121, and extending the full length of the device. The zinc diffusion region 122 extends partially into the second inactive layer 116.

The channels 120 and 121 are each etched with a suitable etchant, such as a solution of sulfuric acid and hydrogen peroxide ($H_2SO_4:H_2:H_2O$), to a depth of approximately 1.5 microns (1.5 x $10^{-6}$ meter) and a width of approximately 2-5 microns. The center-to-center spacing of the channels is approximately 4-10 microns.

In the embodiment of FIG. 10 the thickness of the active layer 114 is in the range 40-100nm (400-1,000 angstroms). The first inactive layer 112 is approximately 0.6 micron thick and the second inactive layer is approximately 1.8 microns thick. The top layer 118 is approximately 0.5 micron thick.

As in the other embodiments, one of the dimensions that has to be selected and controlled with care to ensure proper operation of the structure in accordance with the invention, is the depth of the first inactive layer 112 in the intermediate region above the mesa 126 formed between the two channels 120 and 121. In this regard, essentially the same considerations apply to this embodiment as were described with reference to the FIG. 1 embodiment.

Not shown in FIG. 10, but needed for operation of the laser structure, is a conventional electrical contact adjacent to the zinc diffusion region 122 and another electrical contact beneath the substrate 10. For test purposes, the structure shown in FIG. 10 was soldered onto either a silicon or a diamond submount, which was then mounted onto a copper block to provide the substrate connection.

The output power in milliwatts (mW) obtainable from the structure of FIG. 10 is plotted in FIG. 11 as a function of injected current in milliamperes (mA). In the example shown, a maximum output power of 80 mW was reached before catastrophic damage occurred. Tests on a number of similar structures yielded maximum power figures of 50 mW or more. The power-current relationship is practically linear for both silicon-mounted and diamond-mounted structures.

It is well known that the threshold current of a semiconductor laser increases with temperature.

Basically, the threshold current is a function of $T/T_0$, where T is the temperature and $T_0$ is a constant. For most conventional CSP lasers, $T_0$ is around 140-160 degrees C. However, the structure of the invention has a value of $T_0$ in the range of 180-200 degrees C. Accordingly, the structure of the invention has reduced temperature dependence.

FIGs. 12 and 13 show the near-field and far-field radiation distribution patterns for the illustrative structure of FIG. 10. The near-field pattern has three distinct lobes, apparently indicative of the twin channels and the intermediate region between the channels having optical gain. For reasons riot entirely understood, the center lobe provides a higher intensity than the outer lobes that are apparently derived from the principal lasing regions in the channels. More importantly, the far-field pattern consists of only a single lobe centered at zero degrees. The half width of the far-field lobe is in the range of 4-6 degrees in a plane parallel with the active layer 14, and 25-35 degrees in the perpendicular plane.

The brightness, B, of a laser can be defined for a lossless system as:

$$B = (P_T.4\pi)/(\Omega.A),$$

where:

$P_T$ = the optical power output from the laser,

$\Omega$ = the solid angle beamwidth in steradians, and

A = the area of the lasing aperture.

Using experimental data obtained from a laser structure of the type described,

$P_T$ = 50mW

$\Omega$ = 0.08 x 0.4 = 0.035 (approximately)

A = 10 microns x 2 microns,

B = 8.97 x $10^{+7}$ watts/cm$^2$/ steradian.

It is assumed that the solid angle beamwidth is given by the product of the half widths of the optical radiation pattern in planes parallel to and perpendicular to the laser diode junction. Similar calculations for a ten-element array of the prior art yield a brightness of only 6.18 x $10^{+7}$ watts/cm$^2$/steradian, with 150 mW CW optical power.

It will be appreciated from the foregoing that the present invention represents a significant advance in the field of semiconductor lasers. In particular, the invention provides a laser structure capable of operation at high power and brightness levels, in the range 40-150 mW from a single facet, while maintaining lateral as well as longitudinal mode stability. The device of the invention also has a low threshold current, a high efficiency, and reduced sensitivity to temperature changes. Most of these advantages result from the current focusing mechanism provided by the structure of the invention, specifically the multiple-channel configuration and, in part, the curved geometry of the active layer.

## Claims

1. A semiconductor laser diode structure comprising a semiconductor substrate (10) having at least two parallel channels (14,16) formed in one of its surfaces; a first inactive cladding semiconductor layer (20) of the same polarity type material as the substrate (10), overlying the substrate; a second inactive cladding semiconductor layer (24) of the opposite polarity type material; an active semiconductor layer (22) disposed between the first and second inactive layers (20,24); a blocking layer (12) of opposite polarity type material to the substrate (10), disposed between the substrate (10) and the first inactive layer (20) but only in regions outside of the substrate channels, and not in regions overlying or between the channels; means for applying a bias voltage between the inactive layers, to produce optical gain in the device, including a metallization layer (30;30') extending over the substrate channels (14,16); and a substrate mesa (18) separating the channels (14,16) the height of which is less than that of the substrate outside the channels and enables the provision of sufficient thickness in the first inactive layer (20) to yield reduced absorption in the intermediate region between the channels.

2. A semiconductor laser diode structure as set forth in claim 1, wherein: the metallisation layer comprises a contact stripe (30,30') formed in an overlying relationship with the second inactive layer (24).

3. A semiconductor laser diode structure as set forth in claim 2, wherein: the contact stripe (30') is relatively wide in relation to the combined widths of the channels (14,16) to provide a multi-filament optical gain area.

4. A semiconductor laser diode structure as set forth in claim 2, wherein: the contact stripe (30) is relatively narrow and extends only over the channel widths, to provide a single-filament optical gain (34) region centred over the combined channels (14,16).

5. A semiconductor laser diode structure as set forth in any preceding claim, wherein: the active layer (22) is curved convexly toward the substrate (10), to enhance the current focusing mechanism of the structure.

6. A semiconductor laser diode structure as set forth in claim 1,2 or 3, wherein: the active layer (22') is a substantially planar layer.

7. A semiconductor laser diode structure as set forth in any preceding claim, wherein: the substrate (10) and first inactive layer (20) are of p type material; and the second inactive layer (24) and the blocking layer are of n type material.

8. A semi conductor laser diode structure as set forth in claim 7, wherein: the p type substrate (10) is of gallium arsenide (GaAs); there are two parallel channels (14,16) formed in the substrate; the first inactive cladding semiconductor layer (20) is of p type gallium aluminum arsenide of approximately the composition $Ga_{0.65}Al_{0.35}As$; the second inactive cladding semiconductor layer (24) is of n type gallium aluminum arsenide of approximately the composition $Ga_{0.65}Al_{0.35}As$; the active semiconductor layer (22) is of gallium aluminum arsenide of approximately the composition $Ga_{0.94}Al_{0.06}As$; and the blocking layer 12 is of n type gallium arsenide.

9. A semiconductor laser diode structure as set forth in claim 7, wherein: the number of channels is two.

10. A semiconductor laser diode structure as set forth in claim 1 or claim 7, wherein: the thickness of the first inactive layer (20) is greater in the region between channels than it is in areas outside the channels, to provide for close coupling in the region between channels, and yet to contain lasing within the channel regions.

11. A semiconductor laser diode structure as set forth in claim 10, wherein: the first inactive layer (20) is formed by liquid-phase epitaxy, and the substrate region between channels (14,16) is melted back to a lower height during the liquid-phase epitaxy process, thereby producing the desired increased thickness of the first inactive layer in the intermediate region (18) between channels.

12. A semiconductor laser diode structure comprising a semiconductor substrate (10; 110) having at least two parallel channels (14,16; 120,121) formed in one of its surfaces; a first inactive cladding semiconductor layer (20; 112) of a first polarity type material overlying the substrate; a second inactive cladding layer (24; 116) of the opposite polarity type material; and an active semiconductor layer (22; 114) disposed between the first and second inactive layers (20,24; 112,116); a substrate mesa (18; 126) separating the channels (14,16; 120,121), the height of which is less than that of the substrate outside the channels and enables the provision of sufficient thickness in the first inactive layer (20; 112) to yield reduced absorption in the intermediate region between the channels; the dimensions of the channels and/or the active layer in the region of the channels being different whereby to produce at least two principle lasing regions located adjacent to the channels, producing different sets of longitudinal modes and the intermediate region providing coupling between the two principal lasing regions, resulting in a composite output including longitudinal modes common to both lasing regions; and means are provided for applying a bias voltage between the inactive layers.

13. A semiconductor laser structure as set forth in claim 12, further comprising a top semiconductor layer (118) formed over said second inactive layer; and a conductive diffusion region (122) extending through said top layer (118) and into said second inactive layer (116), and extending laterally across both of said channels (120,121).

14. A semiconductor laser as set forth in claim 13, wherein: said substrate is of n type gallium arsenide (GaAs); said first and second inactive layers are of n type and p type, respectively, gallium aluminum arsenide of approximately the composition $Ga_{0.65}Al_{0.35}As$; said active layer is of gallium aluminum arsenide of approximately the composition $Ga_{0.94}Al_{0.06}As$; and said top layer is of n type gallium arsenide.

**Patentansprüche**

1. Aufbau einer Halbleiterlaserdiode, mit einem Halbleiter-Substrat (10) mit wenigstens zwei in einer seiner Flächen ausgebildeten parallelen Kanälen (14, 16), einer über dem Substrat gelegenen ersten inaktiven, abschirmenden Halbleiterschicht (20) aus einem Werkstoff derselben Polarität wie das Substrat (10), einer zweiten inaktiven, abschirmenden Halbleiterschicht (24) aus einem Werkstoff der entgegengesetzten Polarität, einer zwischen der ersten und der zweiten inaktiven Schicht (20, 24) angeordneten aktiven Halbleiterschicht (22), einer Sperrschicht (12) aus einem Werkstoff der zum Substrat (10) entgegengesetzten Polarität, die zwischen dem Substrat (10) und der ersten inaktiven Schicht (20), jedoch nur in Bereichen außerhalb der Substratkanäle und nicht in über oder zwischen den Kanälen gelegenen Bereichen angeordnet ist, einer Vorrichtung zum Anlegen einer Vorspannung zwischen die inaktiven Schichten zur Erzeugung einer optischen Verstärkung im Bauteil, einschließlich einer sich über die Substratkanäle (14, 16) erstrekkenden Metallisierungsschicht (30; 30'), und einer die Kanäle (14, 16) trennenden Substratmesa (18), deren Höhe kleiner ist als die des Substrats außerhalb der Kanäle und in der ersten inaktiven Schicht (20) eine Dicke schafft, die zur Erzielung einer reduzierten Absorption im Zwischenbereich zwischen den Kanälen ausreicht.

2. Aufbau einer Halbleiterlaserdiode nach Anspruch 1, bei dem die Metallisierungsschicht einen Kontaktstreifen (30, 30') aufweist, der mit Überlagerung über der zweiten inaktiven Schicht (24) ausgebildet ist.

3. Aufbau einer Halbleiterlaserdiode nach Anspruch 2, bei dem der Kontaktstreifen (30') im Vergleich mit der zusammengefaßten Breite der Kanäle (14, 16) relativ breit ist, derart, daß ein Bereich optischer Verstärkung mit mehreren Filamenten entsteht.

4. Aufbau einer Halbleiterlaserdiode nach Anspruch 2, bei dem der Kontaktstreifen (30) relativ schmal ist und sich nur über die Breite der Kanäle erstreckt, derart, daß ein mittig über der Kanal-Kombination (14, 16) angeordneter Bereich optischer Verstärkung mit einem einzelnen Filament (34) entsteht.

5. Aufbau einer Halbleiterlaserdiode nach einem der vorhergehenden Ansprüche, bei dem die aktive Schicht (22) gegen das Substrat (10) zur Verbesserung des Strombündelungsmechanismus des Aufbaus konvex gekrümmt ist.

6. Aufbau einer Halbleiterlaserdiode nach Anspruch 1, 2 oder 3, bei dem die aktive Schicht (22') eine im wesentlichen ebene Schicht ist.

7. Aufbau einer Halbleiterlaserdiode nach einem der vorhergehenden Ansprüche, bei dem das Substrat (10) und die erste inaktive Schicht (20) aus Werkstoff des p-Typs sind und die zweite inaktive Schicht (24) und die Sperrschicht aus Werkstoff des n-Typs sind.

8. Aufbau einer Halbleiterlaserdiode nach Anspruch 7, bei dem das p-Substrat (10) aus Galliumarsenid (GaAs) ist, im Substrat zwei parallele Kanäle (14, 16) ausgebildet sind, die erste inaktive, abschirmende Halbleiterschicht (20) aus Gallium-Aluminium-Arseniddes p-Typs mit der ungefähren Zusammensetzung $Ga_{0,65}Al_{0,35}As$ ist, die zweite inaktive, abschirmende Halbleiterschicht (24) aus Gallium-Aluminium-Arsenid des n-Typs mit der ungefähren Zusammensetzung $Ga_{0,65}Al_{0,35}As$ ist, die aktive Halbleiterschicht (22) aus Gallium-Aluminium-Arsenid mit der ungefähren Zusammensetzung $Ga_{0,94}Al_{0,06}As$ ist, und die Sperrschicht 12 aus Gallium-Arsenid des n-Typs ist.

9. Aufbau einer Halbleiterlaserdiode nach Anspruch 7, bei dem die Anzahl der Kanäle zwei ist.

10. Aufbau einer Halbleiterlaserdiode nach Anspruch 1 oder Anspruch 7, bei dem die Dicke der ersten inaktiven Schicht (20) im Bereich zwischen den Kanälen größer ist als in den Bereichen außerhalb der Kanäle, derart, daß sich im Bereich zwischen den Kanälen eine enge Kopplung schaffen und doch das Lasern innerhalb der Kanalbereiche halten läßt.

11. Aufbau einer Halbleiterlaserdiode nach Anspruch 10, bei dem die erste inaktive Schicht (20) durch Epitaxie aus der flüssigen Phase ausgebildet worden ist, und der Substratbereich zwischen den Kanälen (14, 16) während des Epitaxievorgangs aus der flüssigen Phase auf eine geringere Höhe nachgeschmolzen worden ist, um dadurch die gewünschte vergrößerte Dicke der ersten inaktiven Schicht im Zwischenbereich (18) zwischen den Kanälen zu erzeugen.

12. Aufbau einer Halbleiterlaserdiode, mit einem HalbleiterSubstrat (10; 110) mit wenigstens zwei in einer seiner Flächen ausgebildeten parallelen Kanälen (14, 16; 120, 121), einer über dem Substrat gelegenen ersten inaktiven, abschirmenden Halbleiterschicht (20; 112) aus einem Werkstoff einer ersten Polarität, einer zweiten inaktiven, abschirmenden Halbleiterschicht (24; 116) aus einem Werkstoff der entgegengesetzten Polarität, einer zwischen der ersten und der zweiten inaktiven Schicht (20, 24; 112, 116) angeordneten aktiven Halbleiterschicht (22; 114), einer die Kanäle (14, 16; 120, 121) trennenden Substratmesa (18; 126), deren Höhe kleiner ist als die des Substrats außerhalb der Kanäle und in der ersten inaktiven Schicht (20; 112) eine Dicke schafft, die zur Erzielung einer reduzierten Absorption im Zwischenbereich zwischen den Kanälen ausreicht, wobei die Abmessungen der Kanäle und/oder der aktiven Schicht im Bereich der Kanäle verschieden sind, wodurch wenigstens zwei hauptsächliche lasernde Bereiche angrenzend an die Kanäle geschaffen sind, die verschiedene Gruppen von Longitudinalmoden erzeugen, und der Zwischenbereich eine Kopplung zwischen den beiden hauptsächlichen lasernden Bereichen schafft, woraus sich ein zusammengesetzter Ausgang mit beiden lasernden Bereichen gemeinsamen Longitudinalmoden ergeben, und eine Vorrichtung zum Anlegen einer Vorspannung zwischen die inaktiven Schichten vorgesehen ist.

13. Aufbau eines Halbleiterlasers nach Anspruch 12, ferner mit einer über der genannten zweiten inaktiven Schicht ausgebildeten oberen Halbleiterschicht (118), und einem elektrisch leitfähigen Diffusionsbereich (122), der die genannte obere Schicht (118) durchdringt und in die genannte zweite inaktive Schicht (116) eindringt und sich seitwärts über beide Kanäle (120, 121) erstreckt.

14. Halbleiterlaser nach Anspruch 13, bei dem das genannte Substrat aus Gallium-Arsenid des n-Typs (GaAs) ist, die genannten ersten und zweiten inaktiven Schichten aus GalliumAluminium-Arsenid des n- bzw. p-Typs mit der ungefähren Zusammensetzung $Ga_{0,65}Al_{0,35}As$ sind, die genannte aktive Schicht aus Gallium-Aluminium-Arsenid mit der ungefähren Zusammensetzung $Ga_{0,94}Al_{0,06}As$ ist, und die genannte obere Schicht aus Gallium-Arsenid des n-Typs ist.

**Revendications**

1. Une structure de diode laser à semiconducteurs comprenant un substrat semiconducteur (10) ayant au moins deux canaux parallèles (14, 16) formés dans l'une de ses surfaces; une première couche de semiconducteur de gaine inactive (20) formée par un matériau du même type de conductivité que le substrat (10), recouvrant le substrat, une seconde couche de semiconducteur de gaine inactive (24) formée par un matériau du type de conductivité opposé; une couche de semiconducteur active (22) disposée entre les première et seconde couches inactives (20, 24); une couche de blocage (12) en un matériau du type de conductivité opposé à celui du substrat (10), placée entre le substrat (10) et la première couche inactive (20), mais seulement dans des régions se trouvant à l'extérieur des canaux de substrat, et non dans des régions recouvrant les canaux ou situées entre ces derniers; des moyens pour appliquer une tension de polarisation entre les couches inactives, afin de produire un gain optique dans le dispositif, comprenant une couche de métallisation( 30; 30') qui s'étend au-dessus des canaux de substrat (14, 16); et une mésa de substrat (18) séparant les canaux (14, 16), dont la hauteur est inférieure à celle du substrat à l'extérieur des canaux, et qui permet l'existence d'une épaisseur suffisante dans la première couche inactive (20) pour produire une absorption réduite dans la région intermédiaire entre les canaux.

2. Une structure de diode laser à semiconducteurs selon la revendication 1, dans laquelle : la couche de métallisation comprend un ruban de contact (30, 30') qui est formé de façon à s'étendre au-dessus de la seconde couche inactive (24).

3. Une structure de diode laser à semiconducteurs selon la revendication 2, dans laquelle le ruban de contact (30') est relativement large par rapport aux largeurs combinées des canaux (14, 16), pour former une région de gain optique à filaments multiples.

4. Une structure de diode laser à semiconducteurs selon la revendication 2, dans laquelle : le ruban de contact (30) est relativement étroit et il s'étend seulement sur les largeurs des canaux, pour former une région de gain optique (34) à un seul filament qui est centrée sur les canaux combinés (14, 16).

5. Une structure de diode laser à semiconducteurs selon l'une quelconque des revendications précédentes, dans laquelle : la couche active (22) est courbée de manière convexe vers le substrat (10) pour renforcer le mécanisme de focalisation de courant de la structure.

6. Une structure de diode laser à semiconducteurs selon la revendication 1, 2 ou 3, dans laquelle : la couche active (22') est une couche pratiquement plane.

7. Une structure de diode laser à semiconducteurs selon l'une quelconque des revendications précédentes, dans laquelle : le substrat (10) et la première couche inactive (20) sont en matériau de type p; et la seconde couche inactive (24) et la couche de blocage sont en matériau de type n.

**8.** Une structure de diode laser à semiconducteurs selon la revendication 7, dans laquelle : le substrat de type p (10) consiste en GaAs; deux canaux parallèles (14, 16) sont formés dans le substrat; la première couche de semiconducteur de gaine inactive (20) consiste en arséniure de gallium-aluminium de type p ayant approximativement la composition $Ga_{0,65}Al_{0,35}As$; la seconde couche de semiconducteur de gaine inactive (24) consiste en arséniure de gallium-aluminium de type n ayant approximativement la composition $Ga_{0,65}Al_{0,35}As$; la couche de semiconducteur active (22) consiste en arséniure de gallium-aluminium ayant approximativement la composition $Ga_{0,94}Al_{0,06}As$; et la couche de blocage (12) consiste en arséniure de gallium de type n.

**9.** Une structure de diode laser à semiconducteurs selon la revendication 7, dans laquelle : le nombre de canaux est égal à deux.

**10.** Une structure de diode laser à semiconducteurs selon la revendication 1 ou la revendication 7, dans laquelle : l'épaisseur de la première couche inactive (20) est plus grande dans la région comprise entre les canaux que dans les régions situées à l'extérieur des canaux, pour produire un couplage serré dans la région située entre les canaux, en confinant néanmoins l'effet laser à l'intérieur des régions des canaux.

**11.** Une structure de diode laser à semiconducteurs selon la revendication 10, dans laquelle : la première couche inactive (20) est formée par épitaxie en phase liquide, et la région de substrat entre les canaux (14, 16) est refondue jusqu'à une hauteur inférieure pendant le processus d'épitaxie en phase liquide, pour produire ainsi l'épaisseur accrue désirée de la première couche inactive dans la région intermédiaire (18) entre les canaux.

**12.** Une structure de diode laser à semiconducteurs comprenant un substrat semiconducteur (10; 110) ayant au moins deux canaux parallèles (14, 16; 120, 121) formés dans l'une de ses surfaces; une première couche de semiconducteur de gaine inactive (20; 112) en un matériau d'un premier type de conductivité, recouvrant le substrat; une seconde couche de gaine inactive (24; 116) en un matériau du type de conductivité opposé; une couche de semiconducteur active (22; 114) placée entre les première et seconde couches inactives (20, 24; 112, 116); une mésa de substrat (18; 126) séparant les canaux (14, 16; 120, 121), dont la hauteur est inférieure à celle du substrat à l'extérieur des canaux, et qui permet l'existence d'une épaisseur suffisante dans la première couche inactive (20; 112) pour produire une absorption réduite dans la région intermédiaire entre les canaux; les dimensions des canaux et/ou de la couche active dans la région des canaux étant différentes, pour produire ainsi au moins deux régions principales d'émission laser situées dans des positions adjacentes aux canaux, qui produisent différents ensembles de modes longitudinaux, tandis que la région intermédiaire produit un couplage entre les deux régions d'émission laser principales, ce qui fait apparaître une émission composite comprenant des modes longitudinaux communs aux deux régions d'émission laser; et des moyens incorporés dans le but d'appliquer une tension de polarisation entre les couches inactives.

**13.** Une structure de laser à semiconducteurs selon la revendication 12, comprenant en outre une couche de semiconducteur supérieure (118) qui est formée sur la seconde couche inactive; et une région de diffusion conductrice (122) qui s'étend à travers la couche supérieure (118) et pénètre dans la seconde couche inactive (116), et qui s'étend latéralement sur les deux canaux (120, 121).

**14.** Un laser à semiconducteurs selon la revendication 13, dans lequel : le substrat consiste en arséniure de gallium (GaAs) de type n; les première et seconde couches inactives consistent respectivement en arséniure de gallium-indium de type n et de type p, ayant approximativement la composition $Ga_{0,65}Al_{0,35}As$; la couche active consiste en arséniure de gallium-aluminium ayant approximativement la composition $Ga_{0,94}Al_{0,06}As$; et la couche supérieure consiste en arséniure de gallium de type n.

*Fig. 1*

*Fig. 2*

Fig. 3

Fig. 4

Fig. 5

## Fig. 6

26 30'
24 22'
20
12
~14~ ~18~ ~16~ 10
36' 36'

## Fig. 7

ARBITRARY UNITS

MICRONS

## Fig. 8

ARBITRARY UNITS

50mW
40mW
30mW
10mW

30° 20° 10° 0° 10° 20° 30°

Fig. 9a

Fig. 9b

Fig. 9c

Fig. 9d

# Fig. 10

118
122
116
114
112
120
121
126
~110~

# Fig. 11

OUTPUT POWER (mW): 0, 10, 20, 30, 40, 50, 60, 70, 80, 90

CURRENT (mA): 0, 50, 100, 150, 200, 250, 300, 350, 400, 450

# Fig. 12

NEAR FIELD

RELATIVE INTENSITY

POSITION ALONG JUNCTION

-10μm, -5μm, 0, 5μm, 10μm

# Fig. 13

FAR FIELD

RELATIVE INTENSITY

$\Delta\theta_{1/2} \sim 6°$

-9°, 0, 9°